# EUROPÄISCHE PATENTSCHRIFT

(11) **EP 1 429 371 B1**
(45) Veröffentlichungstag und Bekanntmachung des Hinweises auf die Patenterteilung: **08.04.2009**
(21) Anmeldenummer: 03016958.5
(22) Anmeldetag: 25.07.2003
(51) Int. Cl.: H01L 21/00

(54) **Einrichtung zur Bearbeitung von integrierten Schaltkreisen**
Device for treatment of integrated circuits
Appareil de traitement de structures de circuits intégrés

(30) Priorität: 11.12.2002 DE 10257777
(43) Veröffentlichungstag der Anmeldung: 16.06.2004
(73) Patentinhaber: Atlantic Zeiser GmbH, 78576 Emmingen (DE)
(72) Erfinder: Berndtsson, Anders, 42934 Kullavik (SE)
(74) Vertreter: Kratzsch, Volkhard

(56) Entgegenhaltungen:
- US-A- 5 563 095
- US-A- 5 992 739
- US-B1- 6 283 368

## Beschreibung

Die Erfindung bezieht sich auf eine Einrichtung zur Bearbeitung von integrierten Schaltkreisen durch Kommunikation zwischen diesen und mindestens einer Steuereinheit, mit den Merkmalen im Oberbegriff des Patentanspruchs 1.

Es ist eine Einrichtung für die Bearbeitung integrierter Schaltkreise durch Kommunikation zwischen diesen und mindestens einer Steuereinheit bekannt (US-B1-6 283 368), die einen umlaufend angetriebenen Träger in Form einer Drehscheibe aufweist, welche auf ihrem Umfang mit Kontaktierungsvorrichtungen versehen ist, die als Kommunikationsmittel zur Kommunikation mit den integrierten Schaltkreisen angesehen werden können. Dabei ist die Gestaltung so getroffen, dass sich beim Umlauf der Drehscheibe nacheinander die einzelnen Kontaktierungsvorrichtungen in den Kartenftuß zwischen zwei Führungsschienen einer Transportbahn schieben, entlang denen die einzelnen Karten in Abständen voneinander mit Hilfe einzelner Mitnehmerpaare in Transportrichtung vorwärts bewegt werden. Jede Kontaktierungsvorrichtung kann sich somit nacheinander in den Kartenfluß schieben. Dann wird die jeweilige Karte zwischen zwei Elemente der Kontaktierungsvorrichtung gebracht. Jede Kontaktierungsvorrichtung hat einen Kontaktkopf und eine zugeordnete Personalisierungskarte, die sich auf der gegenüberliegenden Seite der Drehscheibe befindet. Die einzelnen, je Kontaktierungsvorrichtung vorgesehenen Personalisierungskarten sind mit einem Datenverarbeitungssystem verbunden, das außerhalb angeordnet ist. Wenn beim Umlauf der Drehscheibe eine Kontaktierungsvorrichtung an die Station zum Einfügen und Entfernen von Karten kommt, wobei die Kontaktierungsvorrichtung in die Transportbahn zwischen Eingangsführungen und Ausgangsführungen gelangt, wird eine Karte der Kontaktierungsvorrichtung zugeführt und dort klemmend gehalten. Danach erfolgt eine Rotation der Drehscheibe, während der die Personalisierung der in der Kontaktierungsvorrichtung erhaltenen Karte geschieht. Nach einer kompletten Umdrehung der Drehscheibe kehrt die Karte in die Transportbahn zwischen zwei freien Mitnehmern zurück, wozu die Karte von der Kontaktierungsvorrichtung freigegeben wird. Die Drehscheibe wird somit absatzweise in Umfangsrichtung gedreht. Die integrierten Schaltkreise der Karten befinden sich zeitweise an einer Umfangsstelle der Drehscheibe. Das Einbringen in die Kontatkierungsvorrichtungen und Positionieren und Festhalten der Karten darin benötigt eine gewisse Zeit und begrenzt die Durchlaufgeschwindigkeit, so dass die Datenmenge pro Zeiteinheit entsprechend begrenzt ist. Der konstruktive Aufwand und Geräteaufwand ist sehr groß. Die Drehscheibe baut groß und schwer unter Einbeziehung der einzelnen Kontaktierungsvorrichtungen. Das Aufnehmen, Platzieren und Festhalten der einzelnen Karten nacheinander in den mit der Drehscheibe umlaufenden Kontaktierungsvorrichtungen birgt Störungen in sich, die eine Unterbrechung der Bearbeitung zur Folge haben können Vor allem ist nicht sichergestellt, dass dann, wenn die einzelnen Kontaktierungsvorrichtungen nacheinander einzelne Karten mit integriertem Schaltkreis aufnehmen, die Relativpostion des Schaltkreises zum Kontaktkopf mit Nadeln reproduzierbar immer die gleiche ist. Bereits geringfügige Versetzungen können die ordnungsgemäße Funktion gefährden.

Der Erfindung liegt die Aufgabe zugrunde, eine Einrichtung der eingangs genannten Art so auszubilden, dass diese bei einfachem Aufbau eine wesentlich größere Datenmenge pro Zeiteinheit bei der Bearbeitung integrierter Schaltkreise ermöglicht.

Die Aufgabe ist bei einer Einrichtung der eingangs genannten Art gemäß der Erfindung durch die Merkmale im Anspruch 1 gelöst. Weitere vorteilhafte Erfindungsmerkmale und Ausgestaltungen ergeben sich aus den Unteransprüchen. Gegenstand der Erfindung ist ferner ein Verfahren zur Bearbeitung von integrierten Schaltkreisen durch Kommunikation zwischen diesen und mindestens einer Steuereinheit mit den Merkmalen im Patentanspruch 22. Gemäß der Erfindung werden die integrierten Schaltkreise während einer vorgegebenen, für deren Bearbeitung ausreichenden Zeit und/oder Wegstrecke in bleibender Relativposition zu dem mindestens einen Kommunikationsmittel des Trägers gehalten und während dieser Phase bearbeitet. Dabei werden die integrierten Schaltkreise zusammen mit dem Kommunikationsmittel z. B. auf einer Bogenbahn oder statt dessen auf einer geraden Bahn ohne Relativbewegung zueinander bewegt. In dieser Phase der Bewegung des Trägers mit den Kommunikationsmitteln und den integrierten Schaltkreisen ergibt sich eine relativ große Verweilzeit der integrierten Schaltkreise im Bereich der trägerseitigen Kommunikationsmittel, so dass bei gleicher Durchlaufgeschwindigkeit eine wesentlich größere Datenmenge möglich ist. Bei allem ist die Einrichtung einfach und betriebssicher. Für die berührungslose Kommunikation ist als mindestens ein Kommunikationsmittel des Trägers mindestens eine Antenne, insbesondere Spule, vorgesehen, wobei als Antenne eine Sende-/Empfangsahtenne vorgesehen sein kann. In Anpassung daran sind den jeweiligen integrierten Schaltkreisen jeweilige Antennen zugeordnet, die zusammen mit den Schaltkreisen auf oder in der Bahn angeordnet und damit Teile der Bahn sind. Alternativ ist für die berührende Kommunikation das mindestens eine Kommunikationsmittel des Trägers aus mindestens einer Kontaktiereinrichtung, z. B. Form einer Ansammlung von Kontaktnadeln, gebildet. In Zuordnung dazu ist der jeweilige integrierte Schaltkreis mit Kontakten, z. B.

Kontaktflächen, versehen, die bei der Bearbeitung von der Kontaktiereinrichtung kontaktiert werden.

Weitere Einzelheiten und Vorteile der Erfindung ergeben sich aus der nachfolgenden Beschreibung.

Der vollständige Wortlaut der Ansprüche ist vorstehend allein zur Vermeidung unnötiger Wiederholungen nicht wiedergegeben, sondern statt dessen lediglich durch Hinweis auf die Ansprüche darauf Bezug genommen, wodurch jedoch alle diese Anspruchsmerkmale als an dieser Stelle ausdrücklich und erfindungswesentlich offenbart zu gelten haben.

Die Erfindung ist nachfolgend anhand von in den Zeichnungen gezeigten Ausführungsbeispielen näher erläutert. Es zeigen:
- Fig. 1: eine schematische, teilweise geschnittene Seitenansicht der wesentlichen Teile einer Einrichtung zur Bearbeitung von integrierten Schaltkreisen gemäß einem ersten Ausführungsbeispiel,
- Fig. 2: eine schematische perspektivische Ansicht des rotationssymmetrischen Trägers der Einrichtung in Fig. 1,
- Fig. 3: eine schematische Draufsicht einer Bahn gemäß dem ersten Ausführungsbeispiel, in die integrierte Schaltkreise und zugeordnete Antennen eingearbeitet sind,
- Fig. 4: eine schematische perspektivische Ansicht eines Trägers einer Einrichtung gemäß einem zweiten Ausführungsbeispiel,
- Fig. 5: eine schematische Draufsicht einer Bahn gemäß einem zweiten Ausführungsbeispiel, in die kontaktbehaftete integrierte Schaltkreise eingearbeitet sind.

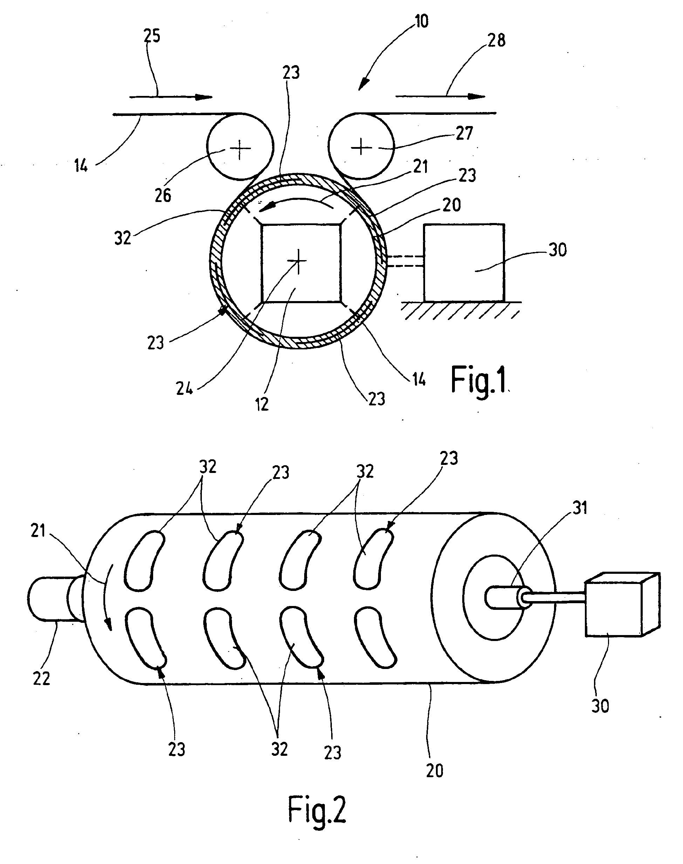

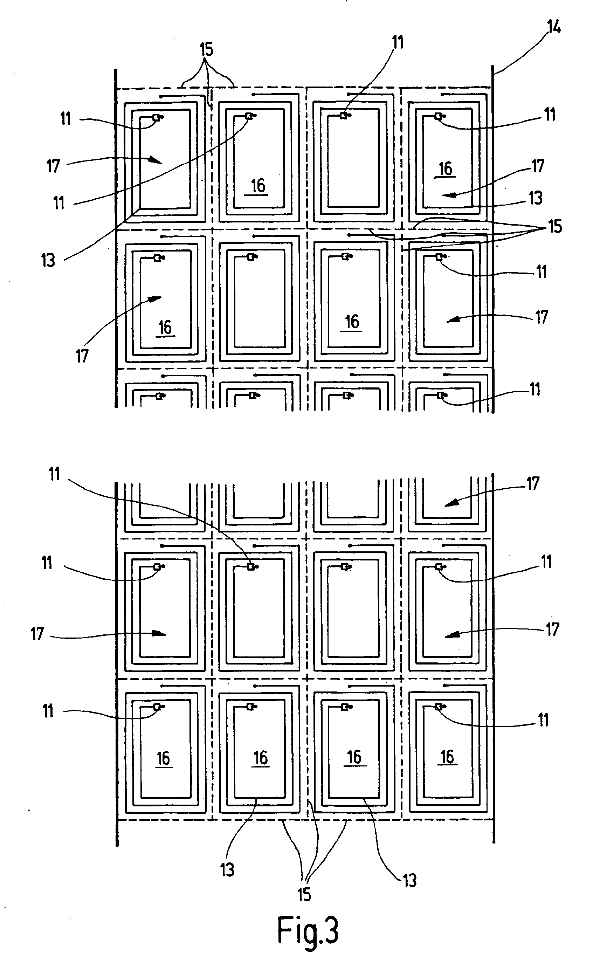

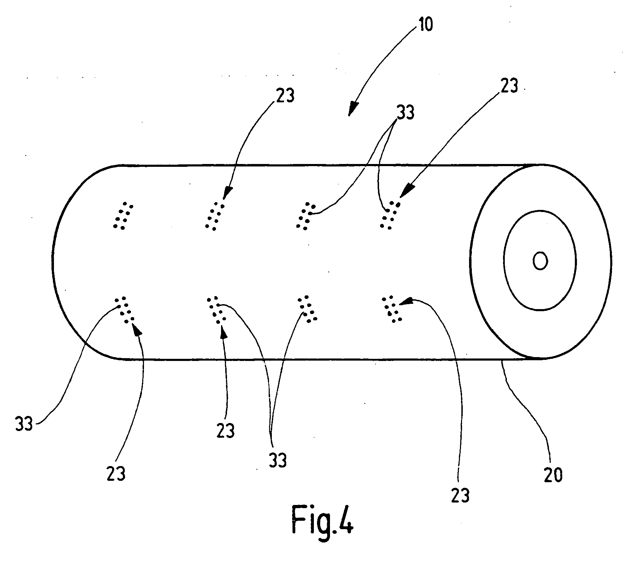

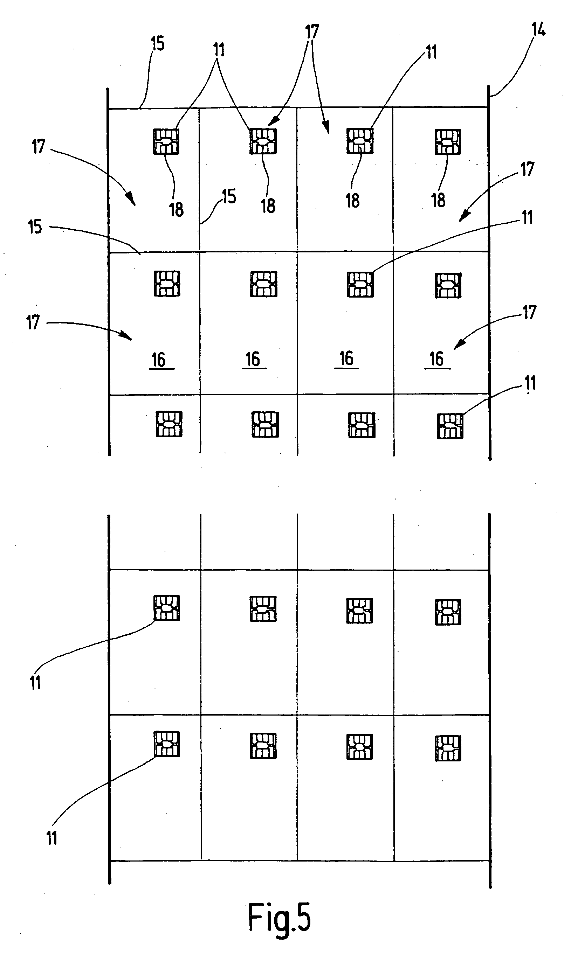

In Fig. 1 bis 3 ist schematisch ein erstes Ausführungsbeispiel einer Einrichtung 10 gezeigt, die zur Bearbeitung von einzelnen in Fig. 3 schematisch angedeuteten integrierten Schaltkreisen 11 durch Kommunikation zwischen letzteren und mindestens einer Steuereinheit 12 dient. Die Steuereinheit 12 ist in Fig. 1 nur schematisch angedeutet und besteht aus einer Steuerelektronik, z. B. einem Steuerrechner. Der Begriff "Bearbeitung" der integrierten Schaltkreise 11 umfasst jedwege Kommunikation, z. B. die Zuführung von Informationen, das Auslesen von Informationen, das Programmieren od. dgl.. Die elektrischen Schaltkreise 11 befinden sich üblicherweise auf einem Substrat, das nicht besonders dargestellt ist. Die Eirichtung 10 gemäß dem ersten Ausführungsbeispiel in Fig. 1 bis 3 ist zur kontaktlosen Kommunikation mit den integrierten Schaltkreisen 11 ausgebildet, während die Einrichtung 10 gemäß dem zweiten Ausführungsbeispiel in Fig. 4 und 5 zur kontaktbehafteten Kommunikation mit den integrierten Schaltkreisen 11 ausgebildet ist.

Wie sich insbesondere aus Fig. 3 ergibt, sind die integrierten Schaltkreise 11 für die kontaktlose Kommunikation mit jeweils zugeordneten Antennen 13 in Form von Spulen verbunden, so dass eine Kommunikation mit den integrierten Schaltkreisen 11 über Funk möglich ist. Die integrierten Schaltkreise 11 mitsamt den zugeordneten jeweiligen Antennen 13 sind Teile einer Bahn 14. Beim gezeigten Ausführungsbeispiel sind die integrierten Schaltkreise 11 mit zugeordneten Antennen 13 insbesondere in die Bahn 14 eingearbeitet. Die Bahn 14 weist z. B. eine mittlere Schicht, in die die integrierten Schaltkreise 11 mit zugeordneten Antennen 13 eingebettet sind, und ferner eine darunter und darüber befindliche Schicht auf. Bei einem anderen, nicht gezeigten Ausführungsbeispiel sind die integrierten Schaltkreise 11 mit zugeordneten Antennen 13 auf der Bahn 14, z. B. auf der Oberseite oder statt dessen auch auf der Unterseite, aufgebacht.

In allen Fällen sind die integrierten Schaltkreise 11 mit zugeordneten Antennen 13 Teile der Bahn 14. Die Bahn 14 ist als Endlosbahn ausgebildet und besteht z. B. aus Papier oder statt dessen auch aus anderen geeigneten bzw. gewünschten Materialien. In Fig. 3 und 5 sind bei der Bahn 14 gestrichelte Linien 15 angedeutet, die signalisieren sollen, dass später nach erfolgter Bearbeitung der integrierten Schaltkreise 11 die durch die Linien 15 umrissenen rechteckförmigen Flächenbereiche 16 der Bahn 14 nach ihrem Zuschneiden einzelne Chipkarten 17 bilden, die bei dem ersten Ausführungsbeispiel mit kontaktloser Kommunikation kontaktlose Chipkarten 17 und beim zweiten Ausführungsbeispiel gemäß Fig. 4 und 5 mit kontaktbehafteter Kommunikation Chipkarten 17 sind, die mit Kontakten 18, z. B. Kontaktflächen, versehen sind. Bei beiden Ausführungsbeispielen weist die Bahn 14, quer zur Bahnlängsrichtung betrachtet, mehrere Längsspuren von integrierten Schaltkreisen 11 (Fig. 5) bzw. von integrierten Schaltkreisen 11 mit jeweils zugeordneten Antennen 13 (Fig. 3) auf, wobei in Fig. 3 und Fig. 5 die Bahn 14 in Form einer Endlosbahn, z. B. Papierbahn, in ebener Ausrichtung dargestellt ist.

Die Einrichtung 10 weist mindestens einen vorzugsweise rotationssymmetrischen Träger 20 auf, der hier als Zylinder, z. B. als Trommel, ausgebildet ist. Der Träger 20 ist in Richtung des Pfeiles 21 umlaufend angetrieben, wobei zum Antrieb z. B. ein Motor 22, z. B. Getriebemotor od. dgl., dient, der in Fig. 2 nur schematisch angedeutet ist. Der Träger 20 ist mit mindestens einem, nur schematisch angedeuteten Kommunikationsmittel 23 zur Kommunikation mit den jeweiligen integrierten Schaltkreisen 11 ausgestattet. Beim Ausführungsbeispiel in Fig. 1 bis 3 weist die Bahn 14 beispielsweise vier Längsspuren jeweils mit vier quer zur Bahnlängsrichtung nebeneinander angeordneten integrierten Schaltkreisen 11 auf. In entsprechender Zuordnung ist der Träger 20 ebenfalls mit vier gleichartigen Kommunikationsmitteln 23 versehen, die in Umfangsrichtung in etwa gleichen Abständen voneinander angeordnet sind und in Richtung der Drehachse 24 des Trägers 20 betrachtet in gleichen Querabständen voneinander angeordnet sind wie die vier Längsspuren der Bahn 14, insbesondere die jeweiligen Antennen 13.

Für die Bearbeitung der integrierten Schaltkreise 11 als Teile der Bahn 14 wird die Bahn 14 um den Träger 20, diesen auf einem Umfangswinkel z. B. von mehr als 180° umschlingend, herumgeführt (Fig. 1). Die Bahn 14 wird hierzu in Richtung des Pfeiles 25 zugeführt, über eine erste Umlenkrolle 26 umgelenkt, von letzterer um die äußere zylindrische Umfangsfläche des Trägers 20 herumgeführt und hiernach über eine zweite Umlenkrolle 27 in Pfeilrichtung 28 abgeführt. Hierbei werden die integrierten Schaltkreise 11 während einer vorgegebenen, für deren Bearbeitung ausreichenden Zeit und/oder Wegstrecke in bleibender Relativposition zu dem mindestens einen Kommunikationsmittel 23 des Trägers 20 gehalten und während dieser Phase bearbeitet. Die integrierten Schaltkreise 11 werden zusammen mit den Kommunikationsmitteln 23 auf einer durch den zylindrischen Umfang des Trägers 20 vorgegebenen Bogenbahn ohne Relativbewegung zwischen den Kommunikationsmitteln 23 einerseits und den integrierten Schaltkreisen 11 mit Antennen 13 andererseits bewegt. Die Bearbeitung der integrierten Schaltkreise 11 erfolgt also während der Umschlingung des Trägers 20. Nach der Bearbeitung werden die Flächenbereiche 16 der Bahn, die jeweils integrierte Schaltkreise 11 und zugeordnete Antennen 13 aufweisen, längs der Linien 15 zugeschnitten, z. B. zertrennt, wodurch sich einzelne Chipkarten 17 bilden, die beim ersten Ausführungsbeispiel kontaktlos sind.

Die Flächenbereiche 16 der Bahn 14 können statt dessen aber auch Tickets, Etiketten oder sonstige Träger der integrierten Schaltkreise 11 mit zugeordneten Antennen 13 sein. Dadurch, dass die Bearbeitung der integrierten Schaltkreise 11 während der Umschlingung des Trägers 20 geschieht, ergibt sich eine relativ lange Verweilzeit der integrierten Schaltkreise 11 mit Antennen 13 auf dem Umfang des Trägers 20 im jeweiligen Bereich der zugeordneten Kommunikationsmittel 23, so dass bei der Bearbeitung der Schaltkreise 11 eine große Datenmenge pro Zeiteinheit ermöglicht ist, und dies in äußerst einfacher und sicherer Weise.

Wie insbesondere aus Fig. 2 und 4 ersichtlich ist, sind die jeweiligen Kommunikationsmittel 23 auf dem zylindrischen Umfang des Trägers 20 angeordnet, hierbei z. B. in einen Zylindermantel eingebettet. Die Steuereinheit 12 ist z. B. Teil des Trägers 20 und ist z. B. in dessen Inneren angeordnet. Sie läuft mit dem Träger 20 um. Die jeweiligen Kommunikationsmittel 23 stehen mit der Steuereinheit 12 in Verbindung. Die Steuereinheit 12 steht ihrerseits berührend oder berührungslos mit mindestens einem stationären, nur schematisch angedeuteten Rechner 30 in Verbindung , wobei die Verbindung mittels einer schematisch angedeuteten Drehübertragungseinrichtung 31 z. B. in Form einer Schleifringeinrichtung, eines optischen Drehverteilers od. dgl. geschieht. Bei der Umlaufbewegung des Trägers 20 führt die um den Träger 20 herumgeführte Bahn 14 zusammen mit dem Träger 20 eine Umlaufbewegung ohne Relativbewegung in Bezug auf den Träger 20 aus.

Der jeweilige Abstand der einzelnen Kommunikationsmittel 23, die in Umfangsrichtung des Trägers aufeinanderfolgen, ist ― auf eine Gerade abgewickelt ― ebenso groß bemessen wie der Abstand, den die in Bahnlängsrichtung in Abständen aufeinanderfolgenden integrierten Schaltkreise 11 mit zugeordneten Antennen 13 aufweisen. Bei der Einrichtung 10 gemäß dem ersten Ausführungsbeispiel, die zur kontaktlosen Kommunikation ausgebildet ist, besteht das jeweilige Kommunikationsmittel 23 des Trägers 20 aus mindestens einer Antenne 32, die in Fig. 2 nur schematisch angedeutet ist und aus einer jeweiligen Spule besteht. In entsprechender Zuordnung dazu hat jeder Schaltkreis 11 eine jeweilige Antenne 13 auf der Bahn 14 bzw. in der Bahn 14.

Beim zweiten Ausführungsbeispiel der Einrichtung sind die Kommunikationsmittel 23 des Trägers 20 zur kontaktbehafteten Kommunikation mit den integrierten Schaltkreisen 11 ausgebildet. Hierbei ist jedes Kommunikationsmittel 23 aus mindestens einer Kontaktiereinrichtung 33 gebildet, die mit den Kontakten 18 jeweiliger zugeordneter integrierter Schaltkreise 11 der Bahn 14 für die Bearbeitung der Schaltkreise 11 in Berührung gelangt. Im übrigen ist die Wirkungsweise der Einrichtung 10 die gleiche wie beim ersten Ausführungsbeispiel.

Bei einem nicht gezeigten Ausführungsbeispiel können mehrere Träger 20, insbesondere Zylinder, in einer Anordnung nebeneinander und/oder hintereinander vorgesehen sein, wobei diese mehreren Träger zu einer Maschine zusammengebaut sein können.

Ferner können die mehreren Träger 20 Kommunikationsmittel 23 für kontaktlose und/oder für kontaktbehaftete Kommunikation aufweisen. Dies impliziert, dass mehrere Träger 20 entweder gleichartige Kommunikationsmittel 23, z. B. in Form von Antennen 32 oder statt dessen in Form von Kontaktiereinrichtungen 33, aufweisen können oder statt dessen auch mit einer Mischung aus kontaktlos oder kontaktbehaftet arbeitenden Kommunikationsmitteln 23, d. h. Antennen 32 und Kontaktiereinrichtungen 33, versehen sein können.

Bei einem anderen, nicht gezeigten Ausführungsbeispiel können die integrierten Schaltkreise 11 zusammen mit den Kommunikationsmitteln 23 auch auf einer geraden Bahn 14 statt auf einer Bogenbahn ohne Relativbewegung zueinander bewegt und während dieser Phase bearbeitet werden.

## Patentansprüche

1. Einrichtung zur Bearbeitung von integrierten Schaltkreisen (11) durch Kommunikation zwischen diesen und mindestens einer Steuereinheit (12), mit mindestens einem umlaufend angetriebenen rotationssymmetrischen Träger (20) mit mindestens einem Kommunikationsmittel (23) zur Kommunikation mit den integrierten Schaltkreisen (11),
**dadurch gekennzeichnet,**
**dass** die Schaltkreise (11) für die Kommunikation auf einer um den Träger (20) herumgeführten Bahn (14) angeordnet sind und dass die um den Träger (20) herumgeführte Bahn (14) mit Schaltkreisen (11) zusammen mit dem Träger (20) eine Umlaufbewegung ohne Relativbewegung zwischen Bahn (14) und Träger (20) ausführt.

2. Einrichtung nach Anspruch 1,
**dadurch gekennzeichnet,**
**dass** der Träger (20) mehrere in Umfangsrichtung in etwa gleichen Abständen voneinander angeordnete Kommunikationsmittel (23) aufweist.

3. Einrichtung nach Anspruch 1 oder 2,
**dadurch gekennzeichnet,**
**dass** der Träger (20), in Richtung seiner Drehachse (24) betrachtet, mehrere in etwa gleichen Querabständen voneinander angeordnete Längsspuren mit jeweiligen Kommunikationsmitteln (23) aufweist.

4. Einrichtung nach einem der Ansprüche 1 bis 3,
**dadurch gekennzeichnet,**
**dass** die jeweiligen Kommunikationsmittel (23) auf dem zylindrischen Umfang des Trägers (20) angeordnet sind, z. B. in einen Zylindermantel eingebettet sind.

5. Einrichtung nach einem der Ansprüche 1 bis 4,
**dadurch gekennzeichnet,**
**dass** die mindestens eine Steuereinheit (12) Teil des Trägers (20) ist und mit diesem umläuft.

6. Einrichtung nach einem der Ansprüche 1 bis 5,
**dadurch gekennzeichnet,**
**dass** die jeweiligen Kommunikationsmittel (23) des Trägers (20) mit der Steuereinheit (12) in Verbindung stehen.

7. Einrichtung nach einem der Ansprüche 1 bis 6,
**dadurch gekennzeichnet,**
**dass** die mindestens eine Steuereinheit (12) im Inneren des Trägers (20) angeordnet ist.

8. Einrichtung nach einem der Ansprüche 1 bis 7,
**dadurch gekennzeichnet,**
**dass** die mindestens eine mit dem Träger (20) umlaufende Steuereinheit (12) berührend oder berührungslos mit mindestens einem zugeordneten stationären Rechner (30) in Verbindung steht.

9. Einrichtung nach Anspruch 8,
**dadurch gekennzeichnet,**
**dass** die Steuereinheit (12) mittels einer Drehübertragungseinrichtung (31), z.B. einer Schleifringeinrichtung, eines optischen Drehverteilers od. dgl., mit dem stationären Rechner (30) in Verbindung steht.

10. Einrichtung nach einem der Ansprüche 1 bis 9,
**dadurch gekennzeichnet,**
**dass** der Träger (20) als Zylinder, z.B. als Trommel, ausgebildet ist.

11. Einrichtung nach einem der Ansprüche 1 bis 10,
**dadurch gekennzeichnet,**
**dass** die integrierten Schaltkreise (11) auf der Bahn (14) aufgebracht sind oder in die Bahn (14) eingearbeitet sind.

12. Einrichtung nach einem der Ansprüche 1 bis 11,
**dadurch gekennzeichnet,**
**dass** die um den Träger (20) herumgeführte Bahn (14) als Endlosbahn, z. B. Papierbahn, ausgebildet ist.

13. Einrichtung nach einem der Ansprüche 1 bis 12,
**dadurch gekennzeichnet,**
**dass** die Bahn (14), quer zur Bahnlängsrichtung betrachtet, mehrere in etwa gleichen Querabständen voneinander angeordnete Längsspuren von integrierten Schaltkreisen (11) aufweist.

14. Einrichtung nach einem der Ansprüche 1 bis 13,
**dadurch gekennzeichnet,**
**dass** der jeweilige Abstand der einzelnen in Umfangsrichtung des Trägers (20) aufeinanderfolgenden Kommunikationsmittel (23) voneinander, auf eine Gerade abgewickelt, ebenso groß bemessen ist wie der Abstand, den die in Bahnlängsrichtung in Abständen aufeinanderfolgenden integrierten Schaltkreise (11) voneinander aufweisen.

15. Einrichtung nach einem der Ansprüche 1 bis 14,
**dadurch gekennzeichnet,**
**dass** die Kommunikationsmittel (23) und die integrierten Schaltkreise (11) zur kontaktlosen und/oder kontaktbehafteten Kommunikation ausgebildet sind.

16. Einrichtung nach Anspruch 15,
**dadurch gekennzeichnet,**
**dass** für die berührungslose Kommunikation das mindestens eine Kommunikationsmittel (23) des Trägers (20) aus mindestens einer Antenne (32), insbesondere Spule, gebildet ist und dass dem jeweiligen integrierten Schaltkreis (11) ebenfalls eine jeweilige Antenne (13), insbesondere Spule, auf oder in der Bahn (14) zugeordnet ist.

17. Einrichtung nach Anspruch 15,
**dadurch gekennzeichnet,**
**dass** für die berührende Kommunikation das mindestens eine Kommunikationsmittel (23) des Trägers (20) aus mindestens einer Kontaktiereinrichtung (33) gebildet ist und dass der jeweilige integrierte Schaltkreis (11) mit Kontakten (18), insbesondere Kontaktflächen, versehen ist.

18. Einrichtung nach Anspruch 16,
**dadurch gekennzeichnet,**
**dass** Flächenbereiche (16) der Bahn (14), die jeweils integrierte Schaltkreise (11) und zugeordnete Antennen (13) aufweisen, nach ihrem Zuschneiden einzelne kontaktlose Chipkarten (17) bilden.

19. Einrichtung nach Anspruch 17,
**dadurch gekennzeichnet,**
**dass** Flächenbereiche (16) der Bahn (14), die jeweils integrierte Schaltkreise (11) aufweisen, nach ihrem Zuschneiden einzelne kontaktbehaftete Chipkarten (17) bilden.

20. Einrichtung nach einem der Ansprüche 1 bis 19,
**dadurch gekennzeichnet,**
**dass** mehrere Träger (20), insbesondere Zylinder, in Anordnung nebeneinander und/oder hintereinander vorgesehen sind.

21. Einrichtung nach Anspruch 20,
**dadurch gekennzeichnet,**
**dass** die mehreren Träger (20) Kommunikationsmittel (23) für kontaktlose und/oder kontaktbehaftete Kommunikation aufweisen.

22. Verfahren zur Bearbeitung von integrierten Schaltkreisen (11) durch Kommunikation zwischen diesen und mindestens einer Steuereinheit (12), mit mindestens einem umlaufend angetriebenen rotationssymmetrischen Träger (20), der mit der Kommunikation mit den integrierten Schaltkreisen (11) dienenden Kommunikationsmitteln (23) versehen ist, die mit der Steuereinheit (11) in Verbindung stehen,
**dadurch gekennzeichnet,**
**dass** die integrierten Schaltkreise zusammen mit dem Träger (20) und den Kommunikationsmitteln (23) auf einer um den Träger (20) herumgeführten Bogenbahn ohne Relativbewegung zwischen Bahn und Träger (20) bewegt werden und während einer vorgegebenen, für deren Bearbeitung ausreichenden Zeit und/oder Wegstrecke in bleibender Relativposition mit den Kommunikationsmitteln (23) des Trägers (20) gehalten und während dieser Phase bearbeitet werden.

## Claims

1. Device for processing integrated circuits (11) by means of communication between the latter and at least one control unit (12), having at least one rotationally symmetric carrier (20) which is driven in a revolving manner and has at least one communication means (23) for communicating with the integrated circuits (11),
**characterized in that,**
for the purpose of communication, the circuits (11) are arranged on a web (14) which is guided around the carrier (20), and **in that** the web (14) which is guided around the carrier (20) and has circuits (11) executes, together with the carrier (20), a revolving movement without relative movement between the web (14) and the carrier (20).

2. Device according to Claim 1,
**characterized in that**
the carrier (20) has a plurality of communication means (23) which are arranged at approximately the same distances from one another in the circumferential direction.

3. Device according to Claim 1 or 2,
**characterized in that**
the carrier (20), when viewed in the direction of its axis of rotation (24), has a plurality of longitudinal tracks which are arranged at approximately the same transverse distances from one another and have respective communication means (23).

4. Device according to one of Claims 1 to 3,
**characterized in that**
the respective communication means (23) are arranged on the cylindrical circumference of the carrier (20), for example are embedded in a lateral cylinder surface.

5. Device according to one of Claims 1 to 4,
**characterized in that**
the at least one control unit (12) is part of the carrier (20) and revolves with the latter.

6. Device according to one of Claims 1 to 5,
**characterized in that**
the respective communication means (23) of the carrier (20) are connected to the control unit (12).

7. Device according to one of Claims 1 to 6,
**characterized in that**
the at least one control unit (12) is arranged inside the carrier (20).

8. Device according to one of Claims 1 to 7,
**characterized in that**
the at least one control unit (12) which revolves with the carrier (20) is connected to at least one associated stationary computer (30) with or without contact.

9. Device according to Claim 8,
**characterized in that**
the control unit (12) is connected to the stationary computer (30) by means of a rotation transmission device (31), for example a slip-ring device, an optical rotary distributor or the like.

10. Device according to one of Claims 1 to 9,
**characterized in that**
the carrier (20) is in the form of a cylinder, for example a drum.

11. Device according to one of Claims 1 to 10,
**characterized in that**
the integrated circuits (11) are applied to the web (14) or are incorporated in the web (14).

12. Device according to one of Claims 1 to 11,
**characterized in that**
the web (14) which is guided around the carrier (20) is in the form of a continuous web, for example a paper web.

13. Device according to one of Claims 1 to 12,
**characterized in that**
the web (14), when viewed transversely with respect to the longitudinal direction of the web, has a plurality of longitudinal tracks of integrated circuits (11), which tracks are arranged at approximately the same transverse distances from one another.

14. Device according to one of Claims 1 to 13,
**characterized in that**
the respective distance between the individual communication means (23), which follow one another in the circumferential direction of the carrier (20), is just as large as the distance between the integrated circuits (11), which follow one another at intervals in the longitudinal direction of the web, when unwound onto a straight line.

15. Device according to one of Claims 1 to 14,
**characterized in that**
the communication means (23) and the integrated circuits (11) are designed for communication with and/or without contacts.

16. Device according to Claim 15,
**characterized in that,**
for the purpose of communication without contact, the at least one communication means (23) of the carrier (20) is formed from at least one antenna (32), in particular a coil, and **in that** the respective integrated circuit (11) is likewise assigned a respective antenna (13), in particular a coil, on or in the web (14).

17. Device according to Claim 15,
**characterized in that,**
for the purpose of communication with contact, the at least one communication means (23) of the carrier (20) is formed from at least one contact-making device (33), and **in that** the respective integrated circuit (11) is provided with contacts (18), in particular contact areas.

18. Device according to Claim 16,
**characterized in that**
surface regions (16) of the web (14) which respectively have integrated circuits (11) and associated antennas (13) form individual chip cards (17) without contacts after they have been cut to size.

19. Device according to Claim 17,
**characterized in that**
surface regions (16) of the web (14) which respectively have integrated circuits (11) form individual chip cards (17) with contacts after they have been cut to size.

20. Device according to one of Claims 1 to 19,
**characterized in that**
a plurality of carriers (20), in particular cylinders, are provided beside one another and/or behind one another.

21. Device according to Claim 20,
**characterized in that**
the plurality of carriers (20) have communication means (23) for communication with and/or without contacts.

22. Method for processing integrated circuits (11) by means of communication between the latter and at least one control unit (12), having at least one rotationally symmetric carrier (20) which is driven in a revolving manner and is provided with communication means (23) which are used for communication with the integrated circuits (11) and are connected to the control unit (11),
**characterized in that**
the integrated circuits are moved, together with the carrier (20) and the communication means (23), on an arcuate path, which is guided around the carrier (20), without relative movement between the web and the carrier (20), and are held in a lasting relative position with the communication means (23) of the carrier (20) for a predefined amount of time and/or distance which suffices to process them and are processed during this phase.

## Revendications

1. Dispositif pour traiter des circuits intégrés (11) par une communication entre ceux-ci et au moins une unité de commande (12), comprenant au moins un support (20) à symétrie rotationnelle entraîné dans un mouvement rotatif, lequel est doté d'au moins un moyen de communication (23) pour communiquer avec les circuits intégrés (11), **caractérisé en ce que** les circuits intégrés (11), pour réaliser la communication, sont disposés sur une bande (14) qui fait le tour du support (20) et que la bande (14) qui fait le tour du support (20) effectue avec les circuits (11), conjointement avec le support (20), un mouvement circulaire sans mouvement relatif entre la bande (14) et le support (20).

2. Dispositif selon la revendication 1, **caractérisé en ce que** le support (20) présente plusieurs moyens de communication (23) espacés par des intervalles approximativement égaux dans le sens du pourtour.

3. Dispositif selon la revendication 1 ou 2, **caractérisé en ce que** le support (20), vu dans le sens de son axe de rotation (24), présente plusieurs pistes longitudinales chacune dotée de moyens de communication (23) et espacées par des intervalles transversaux approximativement égaux.

4. Dispositif selon l'une des revendications 1 à 3, **caractérisé en ce que** les moyens de communication (23) respectifs sont disposés sur le pourtour cylindrique du support (20), par exemple noyés dans une enveloppe cylindrique.

5. Dispositif selon l'une des revendications 1 à 4, **caractérisé en ce que** l'au moins une unité de commande (12) fait partie du support (20) et exécute la rotation avec celui-ci.

6. Dispositif selon l'une des revendications 1 à 5, **caractérisé en ce que** les moyens de communication (23) respectifs du support (20) sont en liaison avec l'unité de commande (12).

7. Dispositif selon l'une des revendications 1 à 6, **caractérisé en ce que** l'au moins une unité de commande (12) est disposée à l'intérieur du support (20).

8. Dispositif selon l'une des revendications 1 à 7, **caractérisé en ce que** l'au moins une unité de commande (12) qui exécute la rotation avec le support (20) est en liaison avec au moins un ordinateur fixe (30) associé.

9. Dispositif selon la revendication 8, **caractérisé en ce que** l'unité de commande (12) est en liaison avec l'ordinateur fixe (30) au moyen d'un dispositif de transmission de la rotation (31), par exemple un dispositif à anneau glissant, un distributeur rotatif optique ou équivalent.

10. Dispositif selon l'une des revendications 1 à 9, **caractérisé en ce que** le support (20) est réalisé sous la forme d'un cylindre, par exemple d'un tambour.

11. Dispositif selon l'une des revendications 1 à 10, **caractérisé en ce que** les circuits intégrés (11) sont appliqués sur la bande (14) ou incorporés dans la bande (14).

12. Dispositif selon l'une des revendications 1 à 11, **caractérisé en ce que** la bande (14) qui circule autour du support (20) est réalisée sous la forme d'une bande sans fin, par exemple une bande en papier.

13. Dispositif selon l'une des revendications 1 à 12, **caractérisé en ce que** la bande (14), vue transversalement par rapport au sens longitudinal de la bande, présente plusieurs pistes longitudinales de circuits intégrés (11) espacées par des intervalles transversaux approximativement égaux.

14. Dispositif selon l'une des revendications 1 à 13, **caractérisé en ce que** l'écart respectif des moyens de communication (23) individuels qui se suivent dans la direction circonférentielle sur le support (20), développé sur une ligne droite, a la même valeur que l'écart que présentent entre eux les circuits intégrés (11) qui se suivent à intervalles dans le sens longitudinal de la bande.

15. Dispositif selon l'une des revendications 1 à 14, **caractérisé en ce que** les moyens de communication (23) et les circuits intégrés (11) sont configurés pour une communication sans contact et/ou avec contact.

16. Dispositif selon la revendication 15, **caractérisé en ce que** pour une communication sans contact, l'au moins un moyen de communication (23) du support (20) est constitué d'au moins une antenne (32), notamment une bobine, et qu'une antenne correspondante (13), notamment une bobine, est associée au circuit intégré (11) respectif sur ou dans la bande (14).

17. Dispositif selon la revendication 15, **caractérisé en ce que** pour la communication avec contact, l'au moins un moyen de communication (23) du support (20) est constitué d'au moins un dispositif d'établissement du contact (33) et que le circuit intégré (11) est muni de contacts (18), notamment de surfaces de contact.

18. Dispositif selon la revendication 16, **caractérisé en ce que** les zones de surface (16) de la bande (14) qui présentent les circuits intégrés (11) respectifs et les antennes (13) associées forment, après avoir été découpées, des cartes à puce (17) sans contact individuelles.

19. Dispositif selon la revendication 17, **caractérisé en ce que** les zones de surface (16) de la bande (14) qui présentent les circuits intégrés (11) respectifs forment, après avoir été découpées, des cartes à puce (17) à contacts individuelles.

20. Dispositif selon l'une des revendications 1 à 19, **caractérisé en ce que** plusieurs supports (20), notamment des cylindres, sont prévus selon une disposition côte à côte et/ou l'un derrière l'autre.

21. Dispositif selon la revendication 20, **caractérisé en ce que** les supports (20) présentent des moyens de communication (23) pour une communication sans contact et/ou avec contact.

22. Procédé pour traiter des circuits intégrés (11) par une communication entre ceux-ci et au moins une unité de commande (12), comprenant au moins un support (20) à symétrie rotationnelle entraîné dans un mouvement rotatif, lequel est doté de moyens de communication (23) servant à la communication avec les circuits intégrés (11), lesquels sont en liaison avec l'unité de commande (12), **caractérisé en ce que** les circuits intégrés (11), conjointement avec le support (20) et les moyens de communication (23), accomplissent un mouvement sur une bande courbe qui fait le tour du support (20) sans mouvement relatif entre la bande et le support (20) et sont maintenus sur une durée et/ou une distance suffisantes pour leur traitement dans une position relative constante avec les moyens de communication (23) du support (20) et traités pendant cette phase.
